# EUROPEAN PATENT APPLICATION

(11) **EP 2 159 766 A1**
(43) Date of publication of application: **03.03.2010**
(21) Application number: 09168707.9
(22) Date of filing: 26.08.2009
(51) Int. Cl.: G08B 13/14, H02J 13/00

(54) **Control and signalling device for photovoltaic modules**

(30) Priority: 29.08.2008 IT MI20081555
(71) Applicant: SEM Services for Electronic Manufacturing S.R.L., 20123 Milano (IT)
(72) Inventor: Resadi, Mario, 23899, Robbiate (IT); Costa, Sara, 20061, Carugate (IT); Cesana, Mario, 20045, Besana Brianza (IT)
(74) Representative: Borsano, Corrado

(57) **Abstract**

A control and signalling device adapted to be integrated in a photovoltaic module and to enable or disable electric energy output in relation to the condition of regular operation of the photovoltaic module. In particular, said device comprises a wireless interface through which it can receive a message. When said message is not received correctly within a certain time lapse, then the output of the module is disabled, making it unusable.

## Description

### Field of the invention

The present invention relates to a control and signalling device for photovoltaic modules.

### State of the art

A solar park is typically composed of thousands of photovoltaic modules mounted at ground level, which cover vast geographical areas exposed to the sun.

As it is not simple to provide efficient surveillance, there is a high risk of theft of the photovoltaic modules, mainly during the night when the module does not output electric energy.

Moreover, there is a black market for recycled photovoltaic modules, in particular in countries in which there are no strict controls and in which there is high demand for these components.

Currently, it is not possible to identify a stolen photovoltaic module through a centralized registry system, although each module has a serial number, which is often applied with adhesive labels and therefore easily removable.

Another problem linked to photovoltaic modules is that when one of them, connected in series in a string with other similar modules, is damaged, the entire string is affected by the malfunction. Having detected the fault on the string, it is necessary to test the modules individually to identify the damaged one.

### SUMMARY OF THE INVENTION

The object of the present invention is to provide a control and signalling device for photovoltaic modules adapted to solve the aforesaid problem preventing theft and recycling of photovoltaic modules.

An object of the present invention is a control and signalling device for photovoltaic modules, in conformity with claim 1, comprising a first pair of input terminal blocks, susceptible of being connected to the terminal blocks of an electric energy source; a second pair of terminal blocks adapted to output the electric energy supplied by said electric energy source, an electronic switch adapted to enable or disable said output of electric energy and processing means adapted to control said electronic switch.

Another object of the present invention is that of presenting an operating method of a control and signalling device for photovoltaic modules, in conformity with claim 8.

A further object of the present invention is to supply a photovoltaic or solar module comprising a control and signalling device adapted to solve the aforesaid problem of the theft and recycling of photovoltaic modules.

Therefore, yet another object of the present invention is a photovoltaic or solar module, comprising a control and signalling device according to claim 9.

A further object of the invention is to supply a data transmission architecture, adapted to guarantee operation of a photovoltaic module comprising a control and signalling device.

The dependent claims describe preferred embodiments of the invention, belonging to the present description.

### Brief description of the figures

Further features and advantages of the invention will be more apparent in the light of the detailed description of a preferred, but not exclusive, embodiment of a control and signalling device for photovoltaic modules, shown by way of nonlimiting example with the aid of the accompanying drawings, wherein:
Fig. 1 represents a block diagram of a control and signalling device;
Fig. 2 represents a diagram of a structured communication network in which the device of Fig. 1 is adapted to operate;

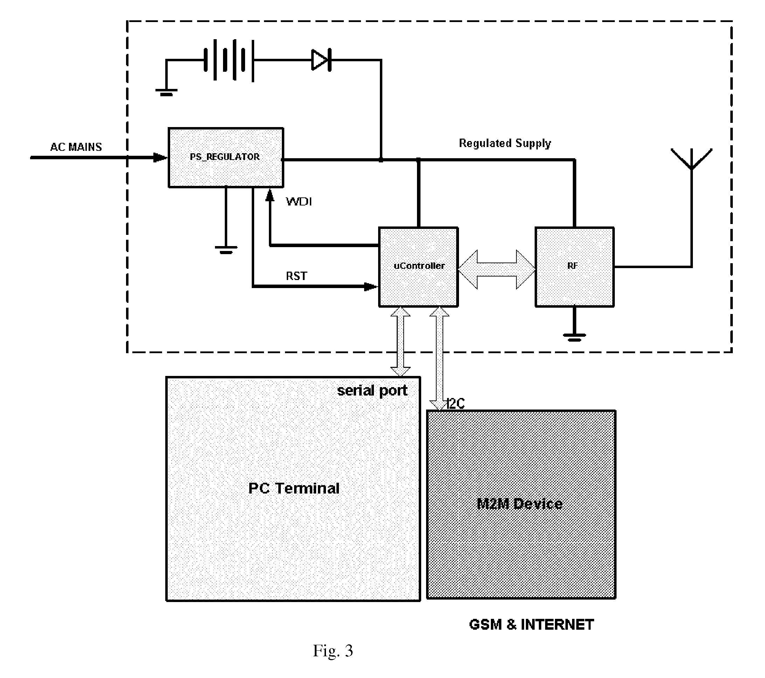

Fig. 3 represents a further block diagram of the control and signalling device of Fig. 1 adapted to take a role of supervisor of a wireless network;

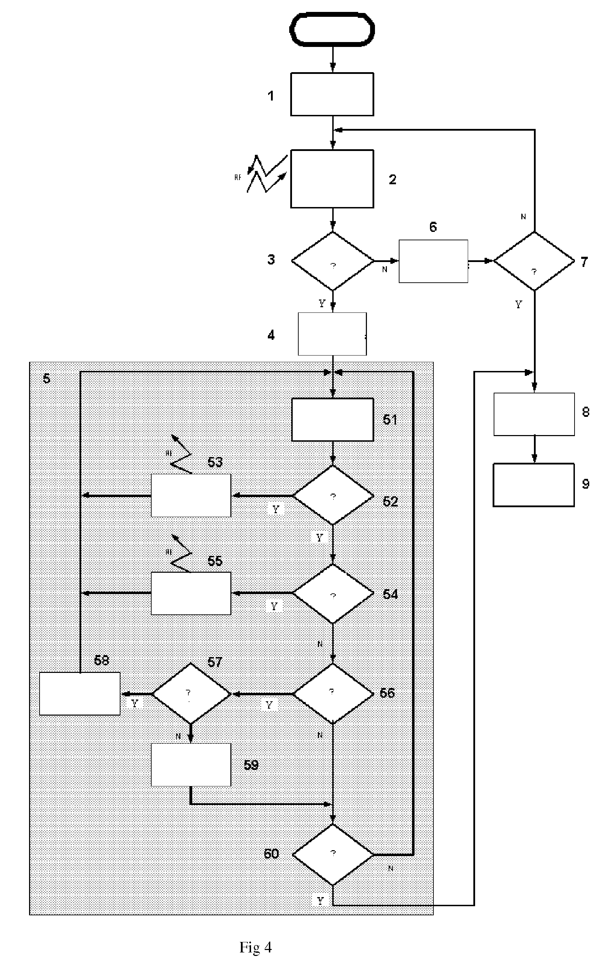

Fig. 4 represents a flow diagram of the operating method of the device indicated in Fig. 1 integrated in a structured communication network.

The same reference numbers and letters in the figures identify the same element or components.

### DETAILED DESCRIPTION OF A PREFERRED EMBODIMENT OF THE INVENTION

A solar power plant according to the present invention comprises a plurality of modules, each comprising a control and signalling device.

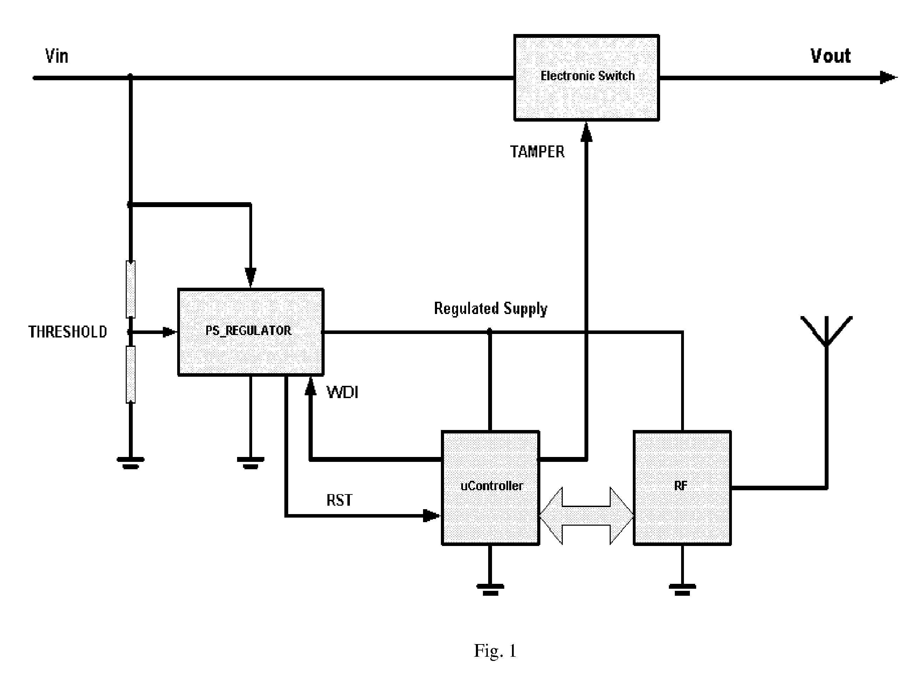

A control and signalling device is described with the aid of the block diagram indicated in Fig. 1.

The symbol Vin represents the voltage generated by the photovoltaic module which can be isolated before being supplied as Vout to the output terminal blocks of the photovoltaic module by an Electronic switch.

Control means represented by the uController block control operation of said Electronic switch. Said control means are adapted to interface with an interface, preferably wireless, represented by the RF block. Moreover, said control means comprise a non volatile memory.

During normal operation of the photovoltaic module, the Electronic switch is continuously on allowing output of the current generated by the module.

Therefore, said control and signalling device comprises a first pair of input terminal blocks Vin susceptible of being connected to the terminal blocks of an electric energy source, a second pair of terminal blocks Vout adapted to output the electric energy supplied by said electric energy source, an Electronic switch adapted to enable or disable said output of electric energy and processing means uController adapted to control said electronic switch.

In a preferred embodiment there is optionally provided a functional element represented by the block with the label PS_Regulator, sandwiched between the supply of the various blocks described above and the input supply of the control and signalling device, and which implements, as hardware supervisor, the following functions:
1. adjusts the supply, Regulated Supply, of the electronic circuits represented by the aforesaid blocks, starting from a minimum threshold (THRESHOLD) of voltage outputted from the photovoltaic module, ensuring reliable operating conditions of the device;
2. upon reaching the minimum threshold, the PS_Regulator generates a rapid reset transition which initializes the uController;
3. if the uController does not continue to pulse the input WDI, the PS_Regulator triggers reset (RST) forcing new initialization of the uController for the purpose of preventing possible block of the uController, also called watchdog function.

According to a preferred embodiment, said RF interface comprises an antenna produced on a printed circuit on which the electronic circuits defining the aforesaid blocks are connected.

Moreover, it is preferred that at least said Electronic switch is located in a concealed position of the photovoltaic module, in such a manner as to prevent easy tampering and/or repair thereof and, if necessary, in such a manner as to make maximum physical damage to the photovoltaic module necessary for this purpose.

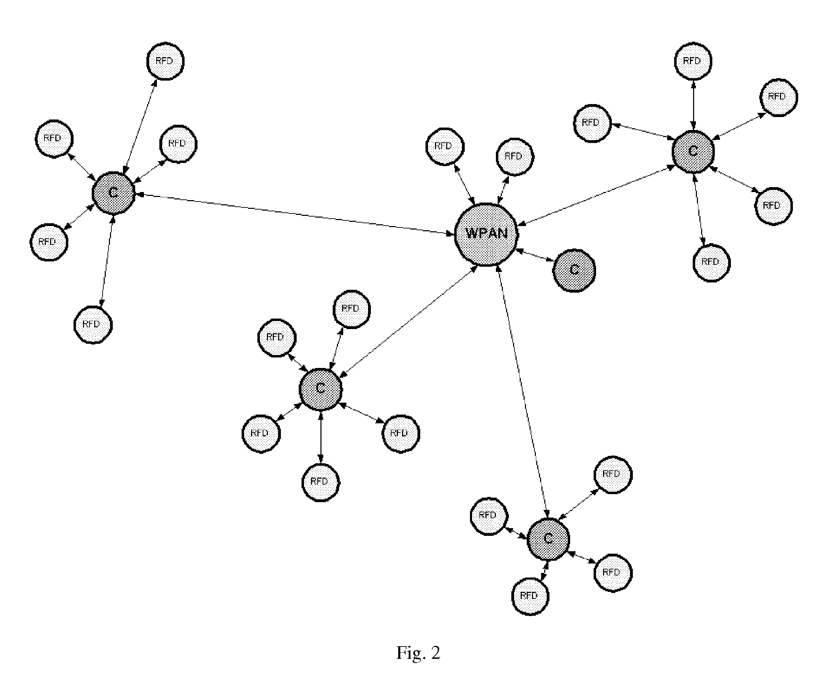

A photovoltaic field, comprising a plurality of photovoltaic modules, defines a network of nodes connected via wireless connection and represented by the initials RFD in Fig. 2.

The network architecture preferred is of hierarchical type, structured by grouping together some adjacent nodes to form cells (cluster). Data transmissions and operation of the photovoltaic modules of each cell is coordinated by a network coordinator (cluster head), indicated with the letter C in Fig. 2.

The nodes RFD communicate prevalently with the coordinator of the cell to which they belong.

Both the nodes RFD and C comprise a control and signalling device in conformity with the above description with the help of Fig. 2.

At the vertices of said hierarchical architecture, there is at least one network supervisor indicated with the initials WPAN adapted to maintain direct communications with the network coordinators of the various cells defining the wireless network for the purpose of controlling operation of said network.

A supervisor WPAN also comprises a control and signalling device in conformity with the above description with the help of Fig. 1, and comprises further processing means, such as a computer, with which it is adapted to interface by means of an RS232 or USB or RJ45 type port and also comprises a Machine-to-Machine type interface, indicated for brevity with M2M in the figures, i.e. an interface adapted to dialog with a GSM/GPRS/UMTS module, for the purpose of transmitting data to another machine. A typical example is remote control of the heating system via gsm modem and telephone.

Said WPAN can optionally be integrated in one of the photovoltaic modules. Therefore, a supervisor comprises the same electronics integrated in each photovoltaic module, besides a second volatile memory for storing key codes of the modules defining the network and operating parameters. For this purpose, constant supply is ensured by means of a specific external safety battery, already known, in order to preserve the data contained in said second volatile memory. The use of a volatile memory is preferred for safety reasons. The optional module M2M is adapted to allow remote monitoring of the network by sending messages from the WPAN to a computer or compatible portable terminal. After installing the photovoltaic modules of at least one photovoltaic field defining a solar power plant in conformity with the present invention, the logic structure of the network most suitable for the area occupied is configured, the coordinators being structurally identical to the other modules.

During normal activity, the supervisor WPAN distributes secret key codes sending strings of encrypted data to the control and signalling devices on the photovoltaic modules, which compare these data with those saved in their non-volatile memories preferably contained in the respective uControllers. If at least one secret key code sent by the WPAN is compatible with a key code stored in a control and signalling device associated with a photovoltaic module, this is maintained active outputting electric current.

Moreover, said device constantly monitors the voltage parameters outputted from the module with which it is associated and optionally of the single string to which said photovoltaic module is connected.

Monitoring can be planned as a routine activity or it can be delegated to the single control and signalling device on each photovoltaic module which, when a fault occurs, sends a message requesting maintenance service (self-diagnostics) to the WPAN through a coordinator.

Therefore, during the night or when the photovoltaic modules are not operating, the secret key codes are in any case stored in the photovoltaic module in said memory included in said control and signalling means.

The supervisor WPAN, always active, can therefore be connected to a wireless communication device of the Machine-to-Machine type through which remote alarms are sent in the form of text messages or through an Internet connection. Various types of alarms can be managed to:
- request maintenance operations;
- indicate damage of a photovoltaic module;
- indicate disconnection or theft of a photovoltaic module.

To maintain the maximum level of network safety, data are encrypted and the encryption key code can be generated with proprietary algorithms.

Each photovoltaic module can be configured with sensitivity thresholds adequate to prevent false alarms.

If an attempt is made to re-use a stolen module, when it is switched on it ceases to output energy after having recognized a tamper condition. In particular, a photovoltaic module which has been removed from its communication network maintains in its non-volatile memory of the control and signalling device a key code relative to its identification in the network. Therefore, in the case in which it is reinstalled in a different network, as it does not receive said string containing said at least one key code, it is no longer able to validate its at least one stored key code, and therefore, after a certain timeout, output of electric current is disabled by said electronic switch. The control and signalling device is adapted to maintain permanently stored the unique serial number of the photovoltaic module with which it is associated and any optional inherent historical data.

Only the manufacturer of the photovoltaic module can retrieve and restore operation of a stolen and recovered photovoltaic module.

Below there is described an operating method of a control and signalling device in conformity with the present invention, when the photovoltaic module associated therewith is correctly positioned in a photovoltaic field.

When the energy outputted by the same photovoltaic module exceeds a specified threshold, step 1 is performed, then the module outputs electric energy to the network; in step 2 an attempt is performed to search for and connect to a wireless network, typically, with a network generated and controlled by a WPAN (supervisor) which is always active; in step 3 success of the operation to connect to the wireless is checked; if the check is passed, in step 4 the TAMPER TIMER is initialized, and in the subsequent step 5 an indefinite duty cycle begins, in which, as can be read below, self-diagnostics, anti-theft control and optionally management of information requests are performed.

In step 51 some operating parameters are measured, such as the voltage produced, and in step 52 it is checked that they are met, otherwise in step 53 it is provided to send a failure message to the WPAN; if said parameters fall within specified limits, then the process passes to step 54, in which it is checked that there is an optional remote information request; in the affirmative case, then, in step 55 a message with the required information is sent, otherwise, the process passes to step 56, in which it is checked that a key code has been received from the WPAN (Supervisor). In step 57 it is checked that said key code is correct, then, if it is correct, in step 58 said TAMPER TIMER is reset to zero, and the process resumes from step 51, otherwise, the process passes to step 59, in which said TAMPER TIMER is increased, and step 60, in which it is checked that it has not exceeded a specified TAMPER TIMEOUT threshold. If said threshold has not been exceeded, the process is resumed from step 51, otherwise, the process passes to step 8, in which said at least one key code is deleted from the non-volatile memory of the device and to step 9 in which current output to the photovoltaic module is disabled. If the check performed in step 3 is instead not passed, then the process passes to step 6 in which the TAMPER TIMER is increased, and step 7 in which if it said TAMPER TIMER is less than the TAMPER TIMEOUT threshold, the process resumes from step 2, otherwise, it passes to step 8 and 9 describe above.

It should be mentioned that following deletion of the key code from the non-volatile memory of the control and signalling device, the photovoltaic module can no longer operate as described unless appropriately reset by the manufacturer, for example through a specific radio signal or through at least partial reprogramming of the same device via a direct wired connection.

It is preferred that said control and signalling device is installed advantageously in the box containing the terminal block of the photovoltaic module, commonly know as junction box.

The advantages deriving from application of the present invention are clear,
a module integrating a device in conformity with the present invention cannot be stolen, as, after a certain time lapse, output of electric energy is definitively inhibited. Moreover, resetting can only be performed, without damaging the module, by the manufacturer of the module.

Moreover, the device allows self-diagnostics to be performed on each module, avoiding having to search for the fault on a string and having to tests modules individually.

Further, the hardware features of a control and signalling device which performs the role of RFD and/or C and/or WPAN can be equal or differentiated in relation to the opportunities of use.

The elements and features illustrated in the different preferred embodiments can be combined without however departing from the scope of protection of the present application.

The particular methods described herein do not limit the content of this application which covers all variants of the invention defined by the claims.

## Claims

1. A control and signalling device for photovoltaic modules, comprising a first pair of input terminal blocks (Vin), susceptible of being connected to the terminal blocks of an electric energy source; a second pair of terminal blocks (Vout) adapted to output the electric energy supplied by said electric energy source; an electronic switch (Electronic switch) adapted to enable or disable said electric energy output; and processing means (uController) adapted to control said electronic switch.

2. The device according to claim 1, further comprising a first communication interface (RF) connected with said processing means, which is adapted to receive a message; said processing means being adapted to control said electronic switch functioning on the basis of said message contents.

3. The device according to claim 2, wherein said first communication interface (RF) is of the wireless type.

4. The device according to claim 2, further comprising first non-volatile storage means, adapted to store a second message; said processing means being adapted to check agreement between said first message and said second message, in order to control said electronic switch functioning.

5. The device according to claim 2, further comprising second volatile-type storage means, adapted to contain a number of messages at least equal to a number of further control and signalling devices to which it is adapted to transmit them.

6. The device according to claim 5, further comprising a power supply source adapted to supply at least said second volatile-type storage means.

7. The device according to one of the preceding claims, comprising a functional element (PS_Regulator) being sandwiched between said first pair of input terminal blocks (Vin) and the power supply terminal blocks of the other components, such as the electronic switch, said processing means, and said interface means; said functional element being adapted to implement:
- adjusting the power supply for the other components, thus ensuring reliable operating conditions thereof;
- generating a reset transition in order to initialize said processing means (uController), even when said processing means result to be blocked.

8. An operating method for a control and signalling device, particularly adapted to be integrated in a photovoltaic module, comprising a first pair of input terminal blocks (Vin), which is susceptible of being connected at the terminal blocks to an electric energy source, such as a photovoltaic module; a second pair of terminal blocks (Vout), which is adapted to output the electric energy produced by said electric energy source; an electronic switch (Electronic switch), which is adapted to enable or disable said electric energy output and processing means (uController), which are adapted to control said electronic switch; and a first communication interface (RF) connected with said processing means, which is adapted to receive a first message; and storage means adapted to contain a second message; said method comprising a step in which, when the energy outputted by the same photovoltaic module exceeds a specified threshold (step 1), then the module outputs electric energy; then, (step 2) an attempt to search for and connect to a wireless network is performed; then, (step 3) if the search for and connect to a wireless network does succeed, (step 4) a timer (TAMPER TIMER) is initialized, then (step 5), an indefinite duty cycle begins; in said indefinite duty cycle (step 51) some operating parameters are measured, such as the voltage at said input terminal blocks (Vin) terminals, then, (step 52) it is checked that they are met, otherwise (step 53), it is provided to send a failure message; on the contrary, if said parameters fall within specified limits, then, (step 54) it is checked that there is an optional remote information request; in the affirmative case, then, (step 55) a message with the required information is sent, otherwise, (step 56) it is checked that a first message has been received; (step 57) it is checked that said first message is compatible with said second message, then, if so, (step 58) said timer is reset to zero (TAMPER TIMER), and the indefinite duty cycle is started again (step 51), otherwise, (step 59) said timer is increased (TAMPER TIMER), and (step 60) it is checked that it has not exceeded a specified threshold (TAMPER TIMEOUT); if said threshold has not been exceeded, the indefinite duty cycle is started again (step 51), otherwise, (step 8) said second message is deleted from said storage means, and (step 9) said energy output is interrupted; if the search for and connection to a wireless network does not succeed (step 3), then, (step 6) said timer (TAMPER TIMER) is increased, and (step 7) if it results to be smaller than said threshold (TAMPER TIMEOUT), then an attempt to search for and connect to a wireless network is performed again (step 2), otherwise, (step 8) said second message is deleted from said storage means, and (step 9) said energy output is interrupted.

9. A photovoltaic or solar module comprising a control and signalling device according to one of the claims 1 to 7.

10. The photovoltaic or solar module according to claim 9, adapted to operate according to the method in accordance with claim 8.

11. A data transmission architecture, comprising a plurality of devices according to one claim 1 to 7, which is hierarchically structured in the form of cells (cluster), each being controlled by a device acting as a cluster head-type network coordinator (C), said network coordinator being adapted to communicate with a network supervisor (WPAN).
